# EUROPEAN PATENT SPECIFICATION

(11) **EP 1 667 160 B1**
(45) Date of publication and mention of the grant of the patent: **23.11.2011**
(21) Application number: 05257422.5
(22) Date of filing: 02.12.2005
(51) Int. Cl.: G11C 11/16

(54) **Magnetic memory device and method**
Magnetspeichervorrichtung und Verfahren
Dispositif et procédé de mémoire magnétique

(30) Priority: 03.12.2004 KR 2004101119; 29.11.2005 US 164579
(43) Date of publication of application: 07.06.2006
(73) Proprietor: Samsung Electronics Co., Ltd., Suwon-si, Gyeonggi-do 442-743 (KR)
(72) Inventor: Hwang, In-jun, Samsung Advanced Inst. of Tech., Giheung-gu Yongin-si, Gyeonggi-do (KR); Kim, Tae-wan, Giheung-gu Yongsin-si, Gyeonggi-do (KR); Jeong, Won-cheol, Dongjak-gu Seoul (KR)
(74) Representative: Greene, Simon Kenneth

(56) References cited:
- US-A1- 2003 026 125
- US-B1- 6 385 083

## Description

### BACKGROUND INFORMATION

Various aspects of Magnetic Random Access Memory (MRAM) devices are described for example in U.S. Patent No. 5,640,343, U.S. Patent No. 6,081,445, U.S. Patent No.6,667,899, U.S. Patent No.6,430,084, U.S. Patent No.6,853,599, U.S. Patent No. 6,815,783, U.S. Patent No.6,781,871, and U.S. Patent No.6,778,428.

An exemplary known MRAM device includes a magnetic tunnel junction (MTJ) having two layers of magnetic material that sandwich a non-magnetic layer. A first one of the magnetic layers, which can be referred to at the "pinned" layer, has a fixed magnetic orientation, and the other magnetic layer, which can be referred to as the "free" layer, has a changeable magnetic orientation. An electrical resistance across the layers of the MTJ varies depending on the magnetic orientation of the free layer with respect to the pinned layer. When the magnetic orientations are parallel (geometrically parallel and pointing in the same direction), the resistance is lower than when the magnetic orientations are anti-parallel (geometrically parallel and pointing in opposite directions). Subjecting the free layer to a magnetic field above a strength threshold can cause the magnetic orientation of the free layer to change, and remain changed after the magnetic field is removed until another magnetic field is applied to change the magnetic orientation of the free layer back to what it was.

U.S. Patent No. 5,640,343 describes, for example, an arrangement where an array of MTJs is placed between electrically conductive lines so that each line on a first side of the array passes over a column of MTJs, and each line on the second, opposite side of the array passes over a row of the MTJs. Thus the array is sandwiched between sets of parallel conductive lines where the lines on one side of the sandwich are perpendicular to the lines on the other side of the sandwich. When a current is passed through one of the lines, it produces a magnetic field that influences each of the MTJs underneath it. The array is configured so that the magnetic field from only one line is not sufficient to change the magnetic orientation of MTJs underneath it, but the combined magnetic field experienced by an MTJ when the lines on both sides of it are activated is sufficient to change the magnetic orientation of that MTJ's free layer (when the fields are opposite to an initial magnetic orientation of the free layer). Thus passing a current through one of the column lines and one of the row lines switches only one MTJ, the MTJ sandwiched between both the column line and the row line at the intersection or crossover region of the column line and the row line. The state of the MTJ (e.g. high or low resistance) can be discerned or read, for example, by applying either a voltage or a current across the MTJ and monitoring the corresponding current or voltage.

Lines to provide magnetic fields to switch one or more MTJs can be bulky and magnetic fields applied to switch an MTJ can adversely affect neighboring MTJs, particularly as size of MTJs and/or MRAM devices containing MTJs is reduced.

United States patent number 6,385,083 discloses a Magnetic Random Access Memory (MRAM) device including an array of cells.

A thin film magnetic memory device including memory cells having a magnetic tunnel junction is disclosed in United States patent application publication number US 2003/0026125 A1.

According to a first aspect of the invention, there is provided a magnetic random access memory device according to claim 1.

According to a second aspect of the invention, there is provided a method for controlling a magnetic random access memory device, the method according to claim 7.

According to another aspect of the invention, there is provided a method of manufacturing a magnetic memory device as claimed in claim 10.

The accompanying drawings provide visual representations which will be used to more fully describe the representative embodiments disclosed herein and can be used by those skilled in the art to better understand them and their inherent advantages. In these drawings, like reference numerals identify corresponding elements.

Figure 1 illustrates exemplary switching behavior of magnetic tunnel junctions in a magnetic random access memory device.

Figure 2 illustrates an exemplary embodiment of a magnetic random access memory device.

Figure 3 illustrates an electronic circuit diagram of the device shown in Figure 2.

Figure 4A illustrates a first exemplary circuit diagram.

Figure 4B illustrates a second exemplary circuit diagram.

Figure 5 illustrates another exemplary magnetic random access memory device.

Figure 6 illustrates an electronic circuit diagram of the device shown in Figure 5.

Figures 7, 8 and 9 illustrate exemplary embodiments of magnetic memory devices.

Figure 10 illustrates exemplary maximum field/current values corresponding to line width and thickness combinations.

Figure 11 illustrates exemplary maximum field/current ratio values corresponding to specific pairs of line width and line thickness values.

Figure 12 illustrates exemplary switching behavior of a magnetic tunnel junction cell having a planar footprint of 0.12 square microns.

Figures 13-15 illustrate exemplary switching behavior of a magnetic tunnel junction cell having a planar footprint of 0.3. square microns, at different digit line currents.

Figures 16-22 illustrate exemplary methods of manufacturing the magnetic memory devices.

### DETAILED DESCRIPTION

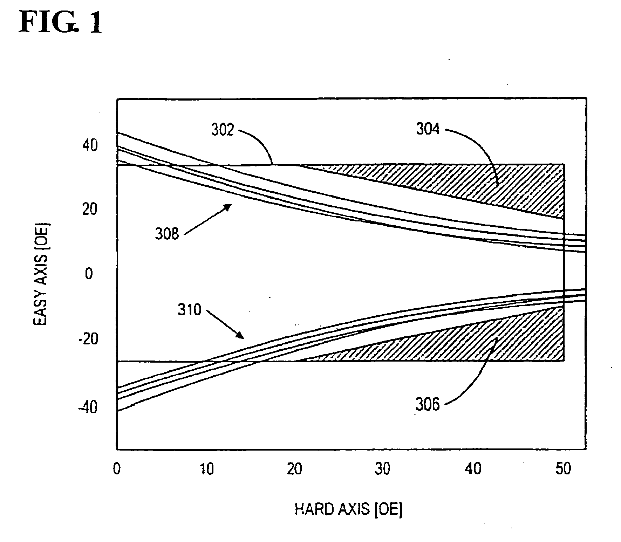

The curves 108, 110 shown in Figure 1 represent exemplary switching behavior of hypothetical MTJs. In particular, each curve represents a set of minimum value combinations of magnetic field strength along the hard and easy axes of an MTJ or MTJ free layer, at which the MTJ will switch. Thus, switching will occur in regions above the curves 108, and below the curves 110. In practice, available magnetic field strength values can be limited, for example to those within the region circumscribed by the box 102. The regions 104 and 106 are within the box 102 but represent sub-regions where the currents and consequent magnetic fields applied to switch an MTJ, also disturb or adversely affect neighboring MTJs. The regions within the box 102 that lie between the sub-regions 104 and the curves 108, and the regions within the box 102 between the curves 110 and the sub-region 106, are the available write windows. As MRAM density is increased, these windows can diminish and become too small to reliably or practically operate the MRAM.

Exemplary embodiments described herein provide methods and configurations that require less switching current, and/or allow higher MRAM densities without adverse switching effects on neighboring MTJ cells.

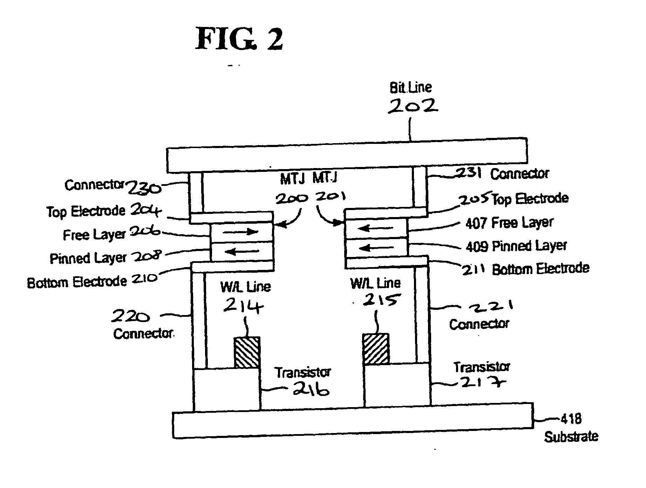

Figure 2 illustrates an exemplary embodiment of a magnetic random access memory device wherein a first magnetic field generating means, e.g. a top electrode 204, has a first portion that covers a surface of a free layer 206 of an MTJ 200. An electric power source including for example the bit line 202 connects to the electrode 204 via a connection (e.g. the connector 203) that covers less than half of the first portion of the top electrode 204, and which can (as shown in Figure 2) cover only a second portion of the electrode 204 wherein the second portion is next to, but does not cover or lie over, the free layer 206. Thus, as shown for example in Figure 2, in an exemplary embodiment a connection of a power source such as the bit line 202 to the top electrode 204 is laterally offset from an electrical connection between the top electrode 204 and the MTJ 200. Thus, current flowing between the connectors 220, 230 will also traverse the top electrode 204 in a direction substantially parallel to a direct connection between the top electrode 204 and the free layer 206 of the MTJ 200, for example in a direction parallel to a plane of the free layer surface covered by the top electrode 204. The combined effect of magnetic fields resulting from electric current flow through the bit line 202 and electric current traversing the top electrode 204 can be sufficient to switch the MTJ 200, and reverse a magnetization direction of the free layer 206. The second magnetic field generating component (e.g., the bottom electrode) 210 can be offset as shown, so return current flowing through the bottom electrode 210 will flow in a direction parallel to the contact surface of the MTJ 200. The electromagnetic field generated by this current flow through the bottom electrode 210 in a direction parallel to the contact surface of the MTJ can affect switching of the MTJ because the magnetic field is generated by the bottom electrode 210 and the top electrode 202 are in the same direction at the MTJ.

In an embodiment, the bottom electrode 210 can have zero offset or zero lateral displacement on the pinned-layer side of the MTJ while the top electrode 204 has an offset. Likewise, the top electrode 204 might not be offset, while the bottom electrode 210 is offset.

The electric current required to switch the MTJ 200 via magnetic fields generated by the bit line 204 and the top electrode 204 is less than that required for switching the MTJs in prior art configurations that do not have this offset. In addition, the digit lines shown in Figure 1 are omitted from the embodiment of Figure 2, which also allows the configuration shown in Figure 2 to be simpler and more compact.

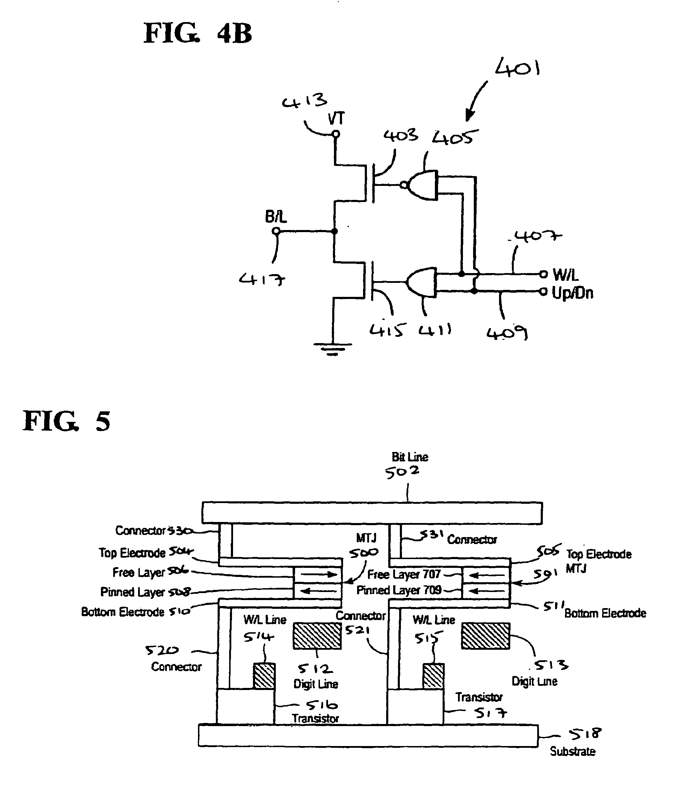

As shown in Figure 2, the MTJ 200 includes both a free layer 206 and a pinned layer 208 which are shown having anti-parallel magnetization directions (i.e., magnetization directions that are geometrically parallel but opposite, resulting in a state of high(er) resistance). Also shown is a bottom electrode 210 that together with a connector 220 connects the pinned layer 208 of the MTJ 200 to a transistor 216 on a substrate 418. As will be apparent from Figure 5, the transistors 216 can be controlled by applying an appropriate voltage or current to a gate of the transistor 216 via the W/L line 214.

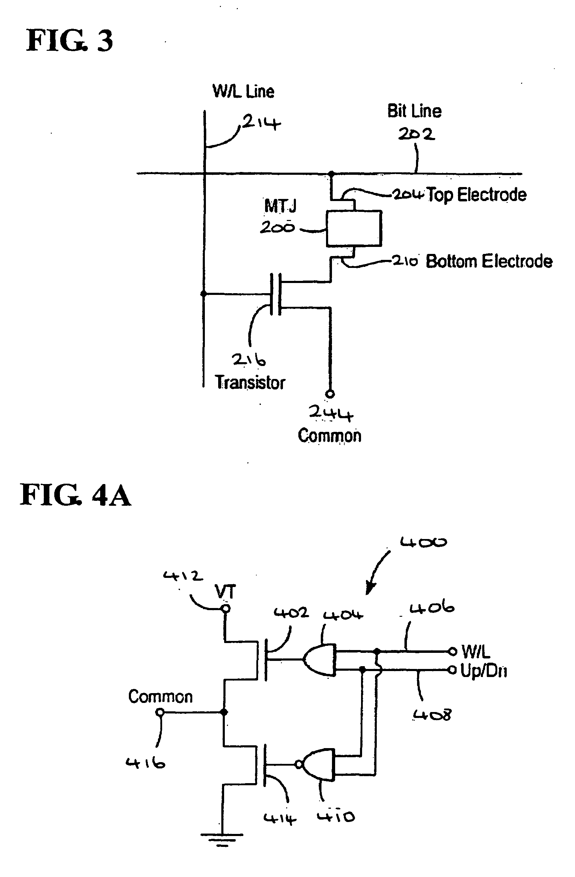

Figure 2 also shows another MTJ 201, connected via a top electrode 205 and a connector 231 to the bit line 202, and connected via a bottom electrode 211 and a connector 221 to a transistor 217 on a substrate 218. The transistor 217 is controlled via a W/L line 215 connected to a gate of the transistor 217, for example in the fashion illustrated in Figure 3. As with the top electrode 204, the top electrode 205 has a connection to the bit line 202 via the connector 231 that is offset from a connection between the top electrode 205 and the MTJ 201. As with the top electrode 204 and the MTJ 200, this offset allows current to traverse the top electrode 205 over the MTJ 201 in a direction parallel to a connection between the top electrode 205 and the MTJ 201, thereby augmenting a magnetic field induced by the bit line 202 in such a way as to switch the MTJ 201 when the current through the bit line 202 and the current traversing the top electrode 205 are sufficient.

As shown in Figure 3, the transistor 216 is controlled via the W/L line 214 connected to its gate, and the source and drain of the transistor 216 are connected to a common connection (e.g., a ground connection) 244 and the bottom electrode 210. In an exemplary embodiment, the transistors 216, 217 are field effect transistors (FETs), in particular, field effect transistors that are partially turned on when a zero voltage is applied to a gate of the transistor, and are fully turned on when a positive voltage is applied to the gate of the transistor. Also note that a circuit diagram representation of the MTJ 201, the transistor 217 and associated components can also correspond to the circuit diagram shown in Figure 3.

As can be seen from Figure 3, the transistor 216 can be used to control (e.g., allow, regulate or prevent) electric current flow between the bit line 202 and the common connection 244 through the MTJ 200. In particular, the transistor 216 can be used to both write a desired state into the MTJ 200, as well as read a present state of the MTJ 200. For example, a first current flowing through the bit line 202 over the MTJ 200 and a second current flowing through the MTJ 200 and traversing the top electrode 204 can together provide a magnetic field sufficient to switch a magnetization direction of the free layer 206 of the MTJ 200. A lesser current through the MTJ 200, and/or a lesser voltage across the MTJ 200 that results in a lesser current so that the MTJ 200 will not be switched, can be applied between the bit line 202 and the common 244 connected to a drain of the transistor 216 to read the state of the MTJ 200 (e.g., to discern whether the MTJ 200 is in a high or low resistance state). In essence, the bit line 202 functions as one pole of an electric power source, and the common 244 shown in Figure 3 functions as another pole of the electric power source.

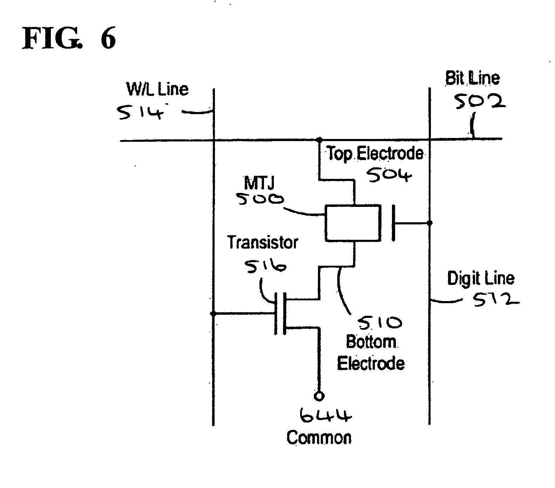

The circuits shown in Figures 4A, 4B can be used for example with the circuits of Figures 3 and 6, to control or operate the MRAM. In particular, the circuit shown in Figure 4A can be used to supply an appropriate voltage to the common (244, 644) connection of the transistor 216, 217, 516, 517, and the circuit shown in Figure 4B can be used to generate an appropriate voltage for application to the bit line 202, 502.

The Table 1 below details operation of the circuits shown in Figures 4A and 4B by showing input signals and corresponding output signals. The output signals can be applied for example to the circuits of Figures 3 and 6. The input signal W/L signal can be the same as that applied to the W/L lines 214, 514 to control the transistors, and the input Up/Dn signal indicates a state to be written to the MRAM/MTJ cell. For a read operation that reads a state of the MTJ cell, the Up/Dn signal is a "don't care" situation - in other words, it does not matter whether the Up/Dn signal is a logical high or a logical low.

**Table 1**

| | | Read | Write | |
|---|---|---|---|---|
| Input | W/L | 0 | 1 | 1 |
| | Up/Dn | (don't care) | 0 | 1 |
| Output | B/L | 1 | 1 | 0 |
| | Common | 0 | 0 | 1 |

Figure 4A shows a circuit receiving a first input signal W/L that is the same as the signal applied to the gate of the transistor 216, 217, 516, 517 and a second input signal "Up/Dn" that indicates a desired state to be written to the MTJ 200, 201, 500, 501. The circuit outputs an appropriate voltage for application to the common (244, 644) connection of the transistor 216, 217, 616, 617. As shown in Figure 4A, the signals W/L and Up/Dn are applied respectively to the lines 406, 408 which feed inputs of an AND gate 404 and a NAND gate 410 which respectively control transistors 402 and 414. In an exemplary embodiment, the transistors 402, 404 are turned off when a logical low voltage is applied to the gate, and are turned on when a logical high voltage is applied to the gate of the transistor. In an exemplary embodiment, the transistors 402, 404 are field effect transistors (FETs) that are off when a logical low voltage is applied to the gate and are on when a logical high voltage is applied to the gate of the transistor. As shown in Figure 4A, a source of the transistor 402 is connected to a voltage source 412 having a voltage VT with the drain connected to an output 416 that supplies a voltage to the common (244, 644) connection of the transistor 216, 217, 616, 617. The gate of the transistor 414 is connected to the output of the logic gate 410, and the source and drain of the transistor 414 are connected between the output terminal 416 and a ground.

Figure 4B illustrates a circuit that receives the input signals W/L and Up/Dn and outputs a corresponding voltage for application to the bit line 202, 502. In particular, the W/L signal is applied to an input 407 which feeds inputs of a NAND gate 405 and an AND gate 411. The Up/Dn signal is supplied via the input 409 to inputs of the logic gates 405 and 411. The logic gates 405 and 411 respectively control transistors 403 and 415, which in an exemplary embodiment are field effect transistors (FETs) that are off when a logical low voltage is applied to the transistor gate and are on when a logical high voltage is applied to the transistor gate. The transistor 403 is connected between a voltage source 413 having a voltage of VT, and an output terminal 417 that supplies an output voltage or signal, which can for example be applied to the bit line 202, 502. The transistor 415 is connected via its source and drain electrodes between the output 417 and ground.

Figure 5 shows another exemplary embodiment which is similar in many respects to the embodiment shown in Figure 4. One difference is that digit lines 512, 513 are respectively provided underneath the MTJs 500, 501. In addition, a lateral displacement between connections of the top electrode 504, 505 to the MTJ 500, 501 and connections between the top electrode 504, 505 and the connectors 530, 531 is greater than a lateral displacement between the top electrode 504, 505 connection to the electric power source (e.g., connectors 530, 531) and the top electrode 504, 505 connection to the MTJ 200, 201 shown in Figure 2. This greater lateral displacement allows, for example, placement of digit lines 512, 513 beneath the MTJs 500, 501. Figure 6 shows a circuit diagram corresponding to the configuration shown in Figure 5.

Figure 5 shows, in particular, a bit line 502 connected to top electrodes 504, 505 via connectors 530, 531. The top electrodes 504, 505 connect respectively to MTJs 500, 501 which each include a free layer 506, 507 and a pinned layer 508, 509. Bottom electrodes 510, 511 respectively connect the MTJs 500, 501 to transistors 516, 517 via connectors 520, 521. The transistors 516, 517 are positioned on a substrate 518, and are respectively controlled by W/L lines 514, 515 connected to the gates of the transistors 516, 517.

When a surface area of the MTJ that faces a top electrode or bottom electrode is large, then the configuration shown in Figure 5 can be used, for example, so that a digit line can help switch the MTJ. When surface area of the MTJ that faces the top electrode or the bottom electrode is sufficiently smaller, then in an exemplary embodiment, the configuration shown in Figure 2 can be used. For example, the configuration shown in Figure 5 can be used when a surface area of the MTJ is greater than or equal to 0.3 square microns and the configuration shown in Figure 2 can be used when an area of the MTJ facing the top electrode or the bottom electrode is less than or equal to 0.12 square microns. Other ranges can also be used, for example, the configuration of Figure 5 can be used when the surface area of the MTJ is greater than 0.12 square microns and the configuration shown in Figure 2 can be used when these surface of the MTJ is less than or equal to 0.3 square microns.

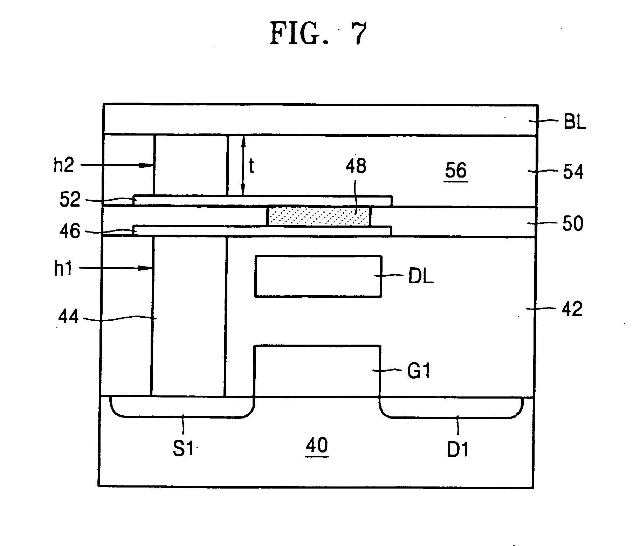

Hereinafter, magnetic memory devices according to embodiments of the present invention each including one MTJ will be described with reference to Figures 7 through 9. Detailed structures of MTJs are not illustrated in Figures 7 through 9.

Referring to Figure 7, in a magnetic memory device according to an embodiment of the present invention including one MTJ, a gate stack G1 including a gate dielectric layer and a gate electrode, which are sequentially stacked, in a predetermined region of a substrate 40. The substrate 40 may be a semiconductor substrate. A source S1 and a drain D1 are formed in regions of the substrate 40 between the gate stack G1 and isolation layers (not shown) existing on both sides of the gate stack G1. The gate stack G1, the source S1, and the drain D1 form a transistor. A digit line DL is located above the gate stack G1. The digit line DL can be used as a magnetic field generating component. Alternatively, the digit line DL may be located above the drain D1. The digit line DL is optional. In other words, the digit line DL may not be formed if required. A first interlayer insulating layer 42 covering the transistor and the digit line DL is formed on the substrate 40. A via hole h1 exposing the source S1 is formed in the first interlayer insulating layer 42. The via hole h1 is filled with a conductive plug 44. A lower electrode pad layer 46 covering an exposed surface of the conductive plug 44 is formed on a planar top surface of the first interlayer insulating layer 42. The lower electrode pad layer 46 is used as a first magnetic field generating component. The thickness and the width of the lower electrode pad layer 46 may be as small as possible. For example, the thickness of the lower electrode pad layer 46 may be 100 nm or less, and the width of the lower electrode pad layer 46 may be 100 nm or less. In addition, in consideration that a magnetic field generated by the lower electrode pad layer 46 is a factor affecting normal magnetization change in an MTJ, it is desirable that the intensity of the magnetic field generated by the lower electrode pad layer 46 is strong. In view of this, it is preferable that the width of the lower electrode pad layer 46 is small. An MTJ 48 is formed in a predetermined region of the lower electrode pad layer 46. The MTJ 48 may be located above the digit line DL. A second interlayer insulating layer 50 covering an exposed surface of the lower electrode pad layer 46 and the side of the MTJ 48 is formed on the first interlayer insulating layer 42. The second interlayer insulating layer 50 may be formed of the same insulating material as for the first interlayer insulating layer. An upper electrode pad layer 52 covering the exposed upper surface of the MTJ 48 is formed on the second interlayer insulating layer 50. The upper electrode pad layer 52 is used as a second magnetic field generating component. The upper electrode pad layer 52 may be located above the lower electrode pad layer 46. The upper electrode pad layer 52 determines the magnetic polarization state of a free magnetic layer of the MTJ 48 together with the lower electrode pad layer 46. In other words, the upper electrode pad layer 52 aligns the magnetic polarization orientation of the free magnetic layer in a fixed magnetic orientation of a pinned layer or in an opposite direction thereto. The upper electrode pad layer 52 may have the same geometrical shape as the lower pad conductive layer 46. A third interlayer insulating layer 54 covering the upper electrode pad layer 52 is formed on the second interlayer insulating layer 50. The third interlayer insulating layer 54 may be formed of the same insulating material as for the first interlayer insulating layer 42. A via hole h2 exposing a portion of the upper electrode pad layer 52 is formed in the third interlayer insulating layer 54. The via hole h2 may be formed above the via hole h1 formed in the first interlayer insulating layer 42. A bit line BL filling the via hole h2 to contact the upper electrode pad layer 52 is formed on the third interlayer insulating layer 54. To increase the selectivity of the MTJ 48, it is desirable to minimize an effect of a magnetic field generated by the bit line BL on the MTJ. Accordingly, the distance 't" between the bit line BL on the third interlayer insulating layer 54 and the upper electrode pad layer 52, which is substantially equal to the thickness of the third interlayer insulating layer 54, is determined to satisfy this requirement. The distance "t" between the bit line BL and the upper electrode pad layer 52 may be, for example, 300 nm.

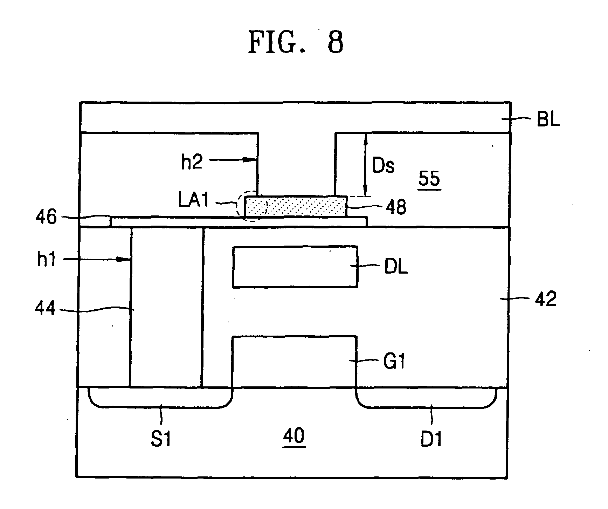

A magnetic memory device according to another embodiment of the present invention including one MTJ will be described with reference to FIG. 8.

Referring to Figure 8, the lower electrode pad layer 46 covering the exposed surface of the conductive plug 44 is formed on the first interlayer insulating layer 42. The lower electrode pad layer 46 is formed as a magnetic field generating component which generates a magnetic field concentrating in a local area LA1. The MTJ 48 is formed on the lower electrode pad layer 46. The MTJ 48 is separated a predetermined distance from the conductive plug 44. A second interlayer insulating layer 55 covering an exposed surface of the lower electrode pad layer 46 and the entire MTJ 48 is formed on the first interlayer insulating layer 42. A via hole h2 exposing a top surface of the MTJ 48 is formed in the second interlayer insulating layer 55. A bit line BL filling the via hole h2 to contact the exposed surface of the MTJ 48 is formed on the second interlayer insulating layer 55. The distance Ds between the bit line BL on the second interlayer insulating layer 55 and the MTJ 48 may be larger than the distance "t" in Figure 7. Although a digit line DL below the lower electrode pad layer 46 is shown in Figure 8, the digit line DL may be not formed.

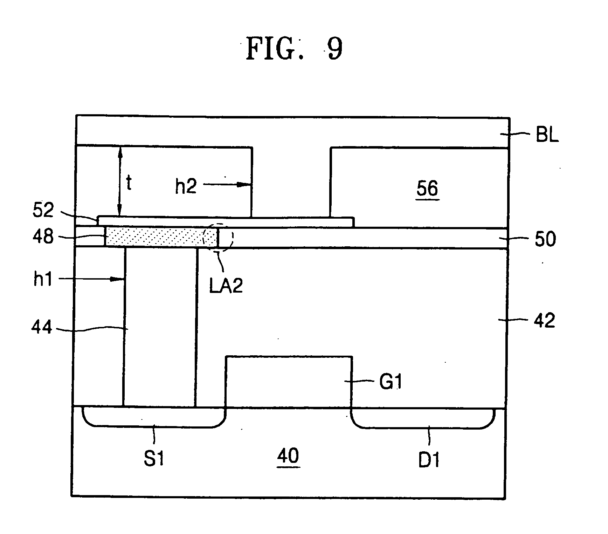

A magnetic memory device according to anther embodiment of the present invention including one MTJ will be described with reference to FIG. 9.

Referring to Figure 9, a contact hole h1 exposing the source S1 is formed in the first interlayer insulating layer 42 covering a transistor. The contact hole h1 is filled with a conductive plug 44. The MTJ 48 covering an exposed surface of the conductive plug 44 is formed on the first interlayer insulating layer 42. The second interlayer insulating layer 50 surrounding sides of the MTJ 48 is formed on the first interlayer insulating layer 42. The upper electrode pad layer 52 contacting the top surface of the MTJ 48 is formed on the second insulating layer 50. The upper electrode pad layer 52 extends a predetermined distance above the gate stack G1. The upper electrode pad layer 52 is used as a magnetic field generating component which generates a magnetic field concentrating in a local area LA2. A third interlayer insulating layer 56 covering the upper electrode pad layer 52 is formed on the second interlayer insulating layer 50. A via hole h2, which exposes a portion of the upper electrode pad 52 and is separated from the MTJ 48, is formed in the third interlayer insulating layer 56. A bit line BL filing the second via hole h2 to contact the exposed surface of the upper electrode pad layer 52 is formed on the third interlayer insulting layer 56.

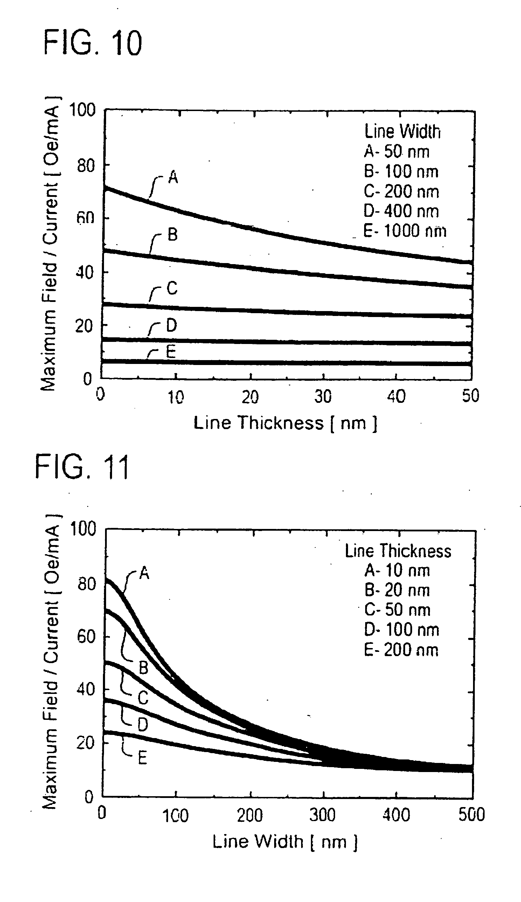

Figures 10 and 11 illustrate maximum magnetic field strength/current ratios with respect to dimensions of a bottom electrode or electrical lines closest to a pinned layer of a MTJ of MRAMs consistent with various embodiments described herein. "Maximum field" refers to the maximum magnetic field generated around the bottom electrode 210, 510 when current flows through the bottom electrode 210, 510. In particular, Figure 10 shows ratios versus line thickness for different line widths, and Figure 11 shows ratios versus line width for different line thicknesses. Figures 10 and 11 show data for an exemplary MTJ whose cumulative thickness for all layers except for the free layer is 20 nanometers, where a line thickness is the dimension of a bottom electrode extending in a direction away from the MTJ and a line width is a dimension of the bottom electrode along a contact surface of the bottom electrode with the MTJ. In an exemplary embodiment, this MTJ consists of a free layer, a pinned layer, an aluminum oxide layer between the free layer and the pinned layer, and a platinum manganese layer between the pinned layer and the bottom electrode.

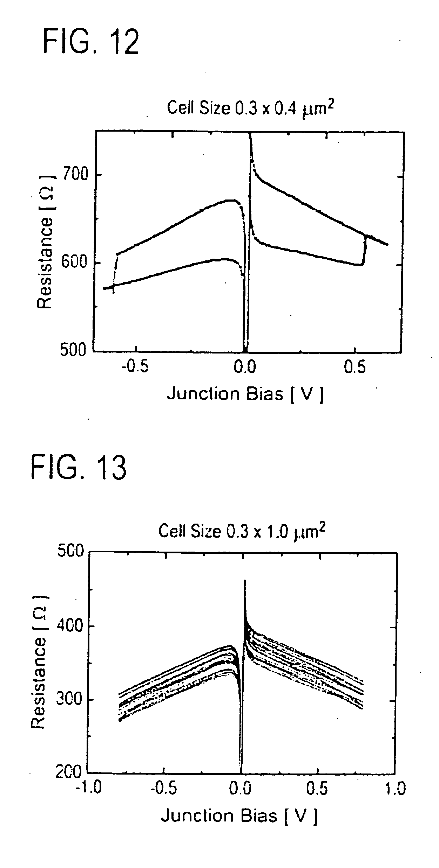

Figure 12 illustrates switching behavior of a exemplary MTJs employed in the configuration shown in Figure 2, wherein an area of each MTJ cell is 0.12 square microns (e.g., 0.3 by 0.4 microns square) and the plot shown in Figure 12 shows a junction bias voltage along the x axis and resistance of the MTJ cell along the y axis. In particular, the uppermost curves at any point along the x axis illustrate a high resistance state and the lower curves illustrate a low resistance state. Transitions between lower and higher curves indicate a switching event of the corresponding MTJ.

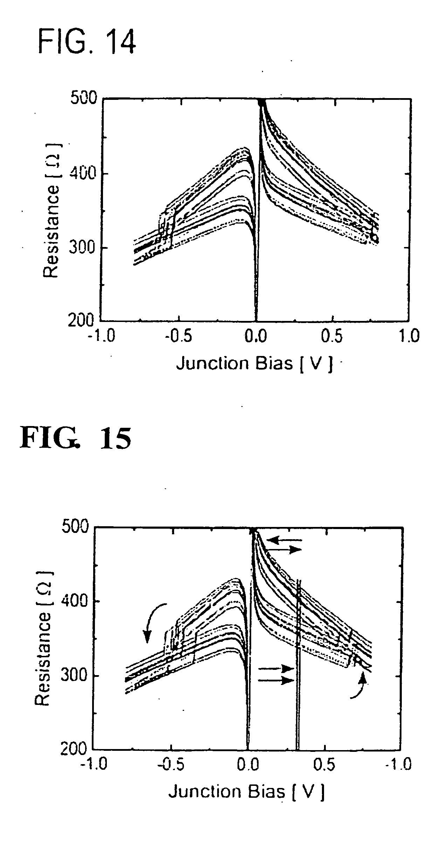

Figures 13-15 illustrate switching behavior of a exemplary MTJ cells having an area of 0.3 square microns (e.g., 0.3 microns by 1 micron square) where resistance of the MTJ cell is indicated on the y axis and a junction bias voltage is indicated on the x axis. The behavior shown in Figures 10-12 corresponds to MTJ cells employed in the configuration of Figure 5, where a digit line 512, 513 is available to influence behavior of the MTJ, e.g., the MTJ 500 or 501. In particular, Figure 13 illustrates behavior of the MTJ cell when a current through the digit line is zero. As can be seen from Figure 13, switching does not occur within the applied junction bias voltage ranges shown in Figure 13 when a digit line current is zero. Figure 14 illustrates behavior of the MTJ given a digit line current of 7.5 milliamperes, and further indicates that switching behavior occurs near junction bias voltages of -0.6 volts and positive 0.7 volts. Figure 15 illustrates that further increasing the digit line current, e.g., 2 milliamperes, allows switching events to occur at lower junction bias voltages. In particular, Figure 15 shows that given a digit line current of 10 milliamperes, switching will occur near a junction bias voltage of -0.5 volts and near a positive junction bias voltage of 0.6 volts. The high resistance curves in Figures 12-15 correspond to anti-parallel magnetic orientations of the free and pinned layers of the MTJs, and the lower resistance curves correspond to parallel magnetic orientations of the free and pinned layers of the MTJs.

A method of manufacturing the magnetic memory device of FIG. 7 will be described.

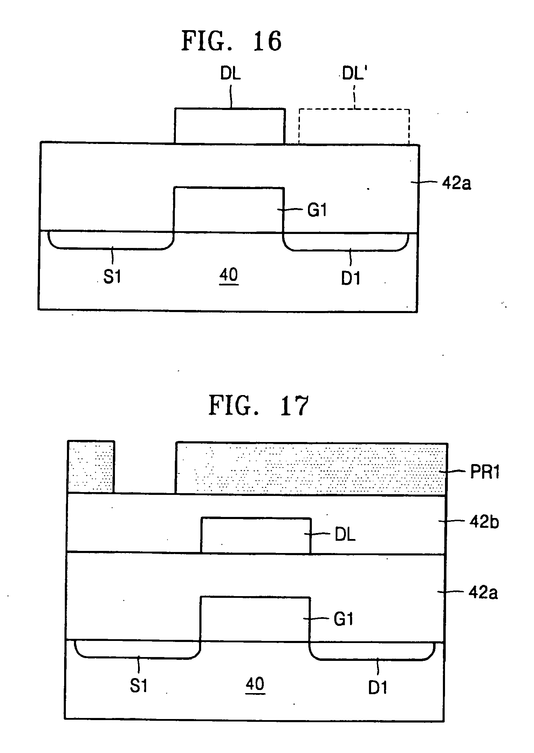

Referring to Figure 16, an active area and a field area are defined in the substrate 40. Next, an isolation layer (not shown) having a predetermined shape is formed in the field region. The substrate 40 may be a semiconductor substrate, for example, a p-type or n-type silicon substrate. The gate stack G1 is formed in a predetermined region of the active area. The gate stack G1 is formed by sequentially stacking a gate dielectric layer, a conductive layer for a gate electrode, and a gate protective layer on the entire surface of the substrate 40, forming a mask (not shown) defining a region on which the gate stack G1 to be formed in the gate protective layer, and etching the stacked material layers in reverse order. After etching the stacked material layers, the mask is removed. The gate stack G1 has spacers (not shown) on its sidewalls.

After forming the gate stack G1, the source S1 and the drain D1 are formed on both sides of the gate stack G1 through an ion doping process, thereby forming a FET on the substrate 40.

To form the magnetic memory devices of Figures 2 and 5, a FET which shares the drain D1 with the FET may be additionally formed on the substrate 40.

Subsequently, a first insulating layer 42a covering the transistor is formed on the substrate 40. The top surface of the first insulating layer 42a is planarized. A digit line DL is formed on a predetermined region of the first insulating layer 42a. Although the digit line DL is formed above the gate stack G1, the digit line DL may be formed above the drain D1 as indicated by dashed lines DL'.

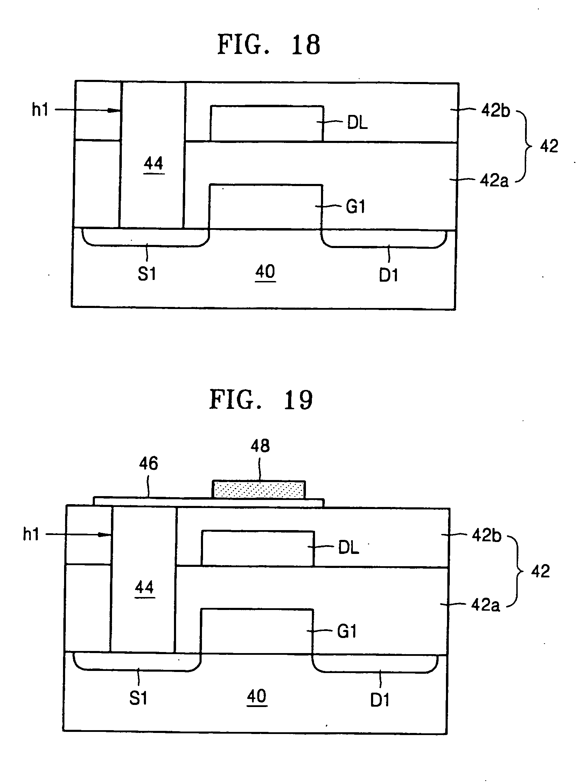

Referring to Figure 17, a second insulating layer 42b covering the digit line DL is formed on the first insulating layer 42a. The top surface of the second insulating layer 42b is planarized. A photoresist pattern PR1 exposing a predetermined region of the second insulating layer 42b above the source S1 is formed on the first insulating layer 42b. The exposed region of the second insulating layer 41 b is etched using the photoresist pattern PR1 as an etching mask. Next, the photoresist pattern PR1 is removed. This etching process is performed until the source S1 is exposed. As a result of the etching process, as illustrated in Figure 18, a via hole h1 exposing the source S1 is formed in the first interlayer insulating layer 42 consisting of the first and second insulating layers 42a and 4b. After the via hole h1 is formed, the via hole h1 is filled with a conductive plug 44. An ohmic contact process may be performed before or after the formation of the conductive plug 44.

Referring to Figure 19, the lower electrode pad layer 46 is formed on the second insulating layer 42b. The lower electrode pad layer 46 is formed to contact the entire exposed surface of the conductive plug 44 and extend above the digit line DL. The lower electrode pad layer 46 can be formed by forming a lower electrode material layer on the second insulating layer 42b and patterning the lower electrode material layer into the lower electrode pad layer 46 using photolithography and etching processes. The lower electrode material layer may be formed to be as thin as possible. For example, the lower electrode material layer may have a thickness of 100 nm or less. In addition, when etching the lower electrode material layer, the lower electrode material layer may be etched to form the lower electrode pad layer 46 having a width that is as small as possible, for example, 100 nm or less. By forming the lower electrode pad layer 46 with a small thickness and width, an magnetic field generated by the lower electrode pad layer 46 as current is supplied to the lower electrode pad layer 46 can be concentrated in the MTJ 48 formed on the lower electrode layer 46. After forming the lower electrode pad layer 46, the MTJ 48 including a pinning layer, a pinned layer, a tunneling layer, a free magnetic layer, etc. is formed on a predetermined region of the lower electrode pad layer 46. Methods of forming the MTJ 48 are widely known. Accordingly, a detailed description thereon will not be provided here. The MTJ 48 may be formed to the side of the lower electrode pad layer 46 away from the conductive plug 44. In this case, the lower electrode pad layer 46 may be located above the digit line DL. In addition, when the digit line DL is formed above the drain D1, as indicated by dashed lines DL' in Figure 7, the lower electrode pad layer 46 extends above the digit line DL, and the MTJ 48 is formed above the digit line DL.

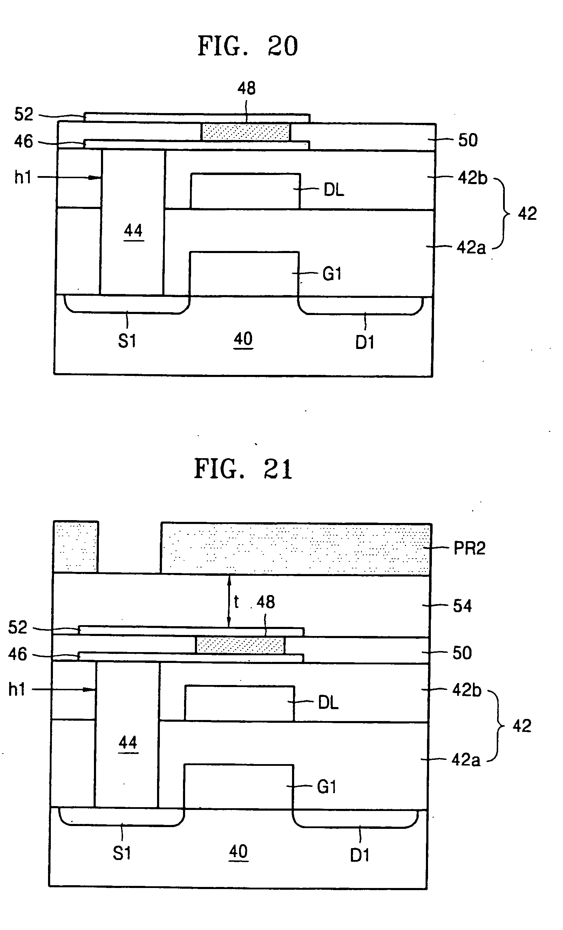

Referring to Figure 20, the second interlayer insulating layer 50 covering the lower electrode pad layer 46 and the MTJ 48 is formed on the first interlayer insulating layer 42. The second interlayer insulating layer 50 may be formed of the same material as for the first interlayer insulating layer 42. After the second interlayer insulating layer 50 is formed, the top surface of the second interlayer insulating layer 50 is polished until the MTJ 48 is exposed. Next, the upper electrode pad layer 52 contacting the entire exposed surface of the MTJ 48 is formed on the second interlayer insulating layer 50. The upper electrode pad layer 52 functions the same as the lower electrode pad layer 46. The upper electrode pad layer 52 may have the same geometrical shape as the lower electrode pad layer 46 and be formed above the lower electrode pad layer 46. The upper electrode pad layer 52 may be formed using the same method as for the lower electrode pad layer 46.

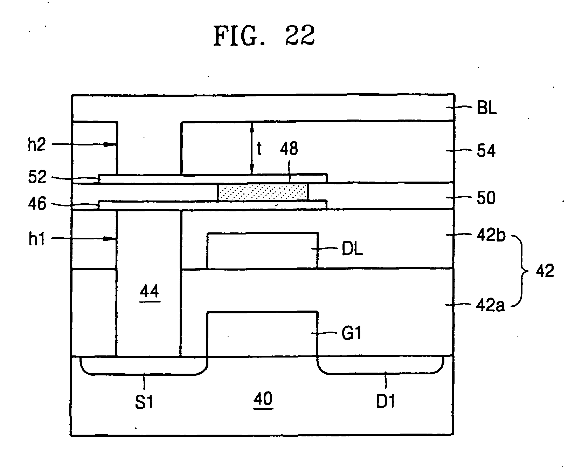

Referring to Figure 21, the third interlayer insulating layer 54 covering the upper electrode pad layer 52 is formed on the second interlayer insulating layer 50. Here, the third interlayer insulating layer 54 is formed such that the distance "t" between the top surface of the upper electrode pad layer 52 and the top surface of the third interlayer insulating layer 54 becomes about 200 nm after a subsequent etching process is formed. The distance "t" may be varied in consideration of the effect of a magnetic field generated by bit lines to be formed in a subsequent process on the MTJ 48. For example, if the magnetic field generated by bit lines can affect the magnetic polarization orientation of the free magnetic layer of the MTJ 48, the distance "t" is determined to be 300 nm or greater. Otherwise, the distance "t" is determined to be smaller than 300 nm. Subsequently, a photoresist pattern PR2 exposing a predetermined region of the third interlayer insulating layer 54 is formed on the third interlayer insulating layer 54. The photoresist pattern PR2 is used to expose a portion of the upper electrode pad layer 52 above the conductive plug 44. Therefore, the photoresist pattern PR2 is formed to expose a portion of the third interlayer insulating layer 54 above the portion of the upper electrode pad layer 52 to be exposed. The exposed portion of the third interlayer insulating layer 54 is etched using the photoresist pattern PR2 as an etching mask. This etching process is performed until the upper electrode pad layer 52 is exposed. Next, the photoresist pattern PR2 is removed. As a result of the etching process, as illustrated in Figure 22, a via hole h2 exposing the portion of the third interlayer insulating layer 54 corresponding to the conductive plug 44 is formed in the third interlayer insulating layer 54. After the via hole h2 is formed, the bit line BL filling the via hole h2 and contacting the exposed portion of the upper electrode pad layer 52 is formed on the third interlayer insulating layer 54.

The magnetic memory devices of Figures 8 and 9 are characterized in that only one of the upper and lower electrode pad layers 52 and 46 is included. Methods of manufacturing the magnetic memory devices of Figures 8 and 9 are substantially the same as the method of manufacturing the magnetic memory device of FIG. 7 including both the upper and lower electrode pad layers 52 and 46, except that the process of forming one of the upper and lower electrode layers 52 and 46 is not performed. Accordingly, detailed descriptions on the methods of manufacturing the magnetic memory devices of Figures 8 and 9 are not provided here.

In addition, in consideration of the structures of the magnetic memory devices of Figures 2 and 5, methods of manufacturing the magnetic memory devices of Figures 2 and 5 are not greatly different from the method of manufacturing the magnetic memory device of FIG. 7. Accordingly, detailed descriptions on the methods of manufacturing the magnetic memory devices of Figures 2 and 5 are not provided here.

For the sake of simplicity, the MTJs shown in Figures 2 and 5 (e.g., MTJs 200, 201, 500, 501) are each shown with only two layers, a free layer and a pinned layer. However, the MTJs can also include additional layers depending on the particular technology or construction techniques used to implement them. For example, each MTJ can include a free layer and a pinned layer with a spacer layer between the free layer and the pinned layer, as well as a pinning layer on an opposite side of the pinned layer from the spacer layer. In addition, although various elements in the Figures 2-6 are illustrated as monolithic or formed out of a single material or component, in fact each can be formed by or include multiple layers or subcomponents. Thus, although various elements may be shown in the Figures in simplified form for purposes of illustration and description, these elements can include any variety of components, subcomponents, connections or features necessary or desirable to perform their respective functions. Although the magnetization directions of the MTJ free layers and pinned layers are shown in Figures 1 and 5 as being parallel or antiparallel to (a) a displacement direction of connections to the top electrodes and bottom electrodes and (b) directions of current flows traversing the top electrodes, the displacement and top electrode current flow directions can be arranged at any desired angle to the magnetization directions. For example, the MTJ can be rotated or oriented around an axis that extends through the top and bottom electrodes and is vertical with respect to the views of Figures 2 and 5.

It will also be appreciated by those skilled in the art that the present invention can be embodied in other specific forms without departing from the essential characteristics thereof, and that the invention is not limited to the specific embodiments described herein. The presently disclosed embodiments are therefore considered in all respects to be illustrative and not restrictive. The scope of the invention is indicated by the appended claims rather than the foregoing description, and all changes that come within the meaning and range and equivalents thereof are intended to be embraced therein. The term "comprising" as used herein is open-ended and not exclusive.

## Claims

1. A magnetic random access memory device, comprising:
a magnetic tunnel junction (200);
first (204) and second (210) magnetic field generating components;
an electric power source comprising: a bit line (202) connected to the first magnetic field generating component (204) via a first connection (230); and a word line (214) connected to the second magnetic field generating component (210) via a second connection (220),
and **Characterized in that**:
the first (204) and second (210) magnetic field generating components contact the magnetic tunnel junction (200) on opposite sides of the magnetic tunnel junction (200);
one pole of the electric power source is connected to the bit line (202) and a second pole is connected to word line (214); and
the first (230) and second (220) connections are laterally offset from the regions of contact between the first (204) and second magnetic (210) field generating components and the magnetic tunnel junction (200).

2. The device of Claim 1, wherein electric current flowing between the first (204) and second (210) magnetic field generating component via the magnetic tunnel junction (200) also traverses the first (204) and second (210) magnetic field generating component along the magnetic tunnel junction (200) in directions that are substantially parallel to the magnetic tunnel junction (200).

3. The of Claim 1 or 2, wherein the magnetic tunnel junction (200) comprises a free layer (206).

4. The device of Claim 3, wherein an area of the free layer surface facing the first magnetic field generating component (204) is less than approximately 0.12 square microns.

5. The device of any of Claims 1 to 3, comprising a digit line (512), wherein the second Magnetic field generating component (210) and the magnetic tunnel junction (200) are located between the first magnetic field generating component (204) and the digit line (512).

6. The device of Claim 5, wherein an area of the free layer surface facing the first magnetic field generating component (204) is larger than about 0.3 square microns.

7. A method for controlling a magnetic random access memory device according to any preceding claim, the method comprising:
switching the device via a first electric current traversing the first (204) and second (210) magnetic field generating component in directions substantially parallel to direct connections between the first (204) and second (210) magnetic field generating component and the magnetic tunnel junction (200).

8. The method of Claim 7, comprising:
reading a state of the magnetic random access memory device via a voltage applied across the first (204) and second (210) magnetic field generating components, wherein a corresponding electric current through the magnetic tunnel junction (200) is less than the first electric current.

9. The method of Claim 7 or 8, wherein the magnetic random access memory device comprises a digit line (512) and the second magnetic field generating component (210) and the magnetic tunnel junction (200) are located between the first magnetic field generating component (204) and the digit line (512), the switching comprising:
applying a second electric current to the digit line (512), simultaneous with the first electric current.

10. A method of manufacturing a magnetic memory device, the method **characterized by** comprising:
forming a transistor in a substrate (40);
forming on the substrate (40) a first interlayer insulating layer (42) covering the transistor;
forming in the first interlayer insulating layer (42) a via hole exposing a source of the transistor;
filling the via hole with a conductive plug (44);
forming on the first interlayer insulating layer a first magnetic field generating component (46) contacting the conductive plug (44); and
forming an magnetic tunnel junction (48), MTJ, on a predetermined region of the first magnetic field generating component (46) laterally offset separated from the conductive plug (44);
forming on the first interlayer insulating layer (42) a second interlayer insulating layer (50) covering the first magnetic field generating component (46) and the MTJ (48);
planarizing the second interlayer insulating layer (50) until a top surface of the MTJ (48) is exposed;
forming on the second interlayer insulating layer (50) a second magnetic field generating component (52) having a first portion contacting the exposed top surface of the MTJ (48);
forming on the second interlayer insulating layer (50) a third interlayer insulating layer (52) covering the second magnetic field generating component (52);
forming in the third interlayer insulating layer (52) a via hole (h2) exposing a second portion of the second magnetic field generating component laterally offset from the first portion; and
forming on the third interlayer insulating layer (54) a bit line (BL) filling the via hole (h2) exposing the second magnetic field generating component (52).

11. The method of claim 10, wherein the first magnetic field generating component (46) is a lower electrode pad layer connecting the conductive plug (44) and the MTJ.

12. The method of claim 11, wherein the width and the thickness of the lower electrode pad layer are 100 nm or less.

13. The method of claim 10, 11 or 12, wherein the MTJ and the bit line are separated by at least 300 nm.

14. The method of any one of claims 10 to 13, wherein the transistor comprises first and second transistors which share one drain, the via hole comprises first and second via holes respectively exposing sources of the first and second transistors, the conductive plug comprises first and second conductive plugs respectively filling the first and second via holes, the first magnetic field generating component comprises a first lower electrode pad layer having a first end portion contacting the first conductive plug and a second lower electrode pad layer having a first end portion contacting the second conductive plug, and the MTJ comprises a first MTJ formed on a second end portion of the first lower electrode pad layer and a second MTJ formed on a second end portion of the second lower electrode pad layer.

15. The method of claim 14, wherein the second magnetic field generating component (52) comprises a first upper electrode pad layer having a first end portion contacting a top surface of the first MTJ and a second end portion contacting the bit line (BL) and a second upper electrode pad layer having a first end portion; contacting a top surface of the second MTJ and a second end portion contacting the bit line (BL).

16. The method of any of claims 10 to 15, wherein the first (46) and second (52) magnetic field generating components are perpendicular to each other.

17. The method of any one of claims 10 to 16, wherein the second magnetic field generating component (52) is an upper electrode pad layer connecting the bit line (BL) and the top surface of the MTJ (48).

18. The method of claim 17, wherein the width and the thickness of the upper electrode pad layer are 100 nm or less.

19. The method of claim 15, wherein the first and second lower electrode pad layers and the first and second upper electrode pad layers have the same thickness and the same width.

## Patentansprüche

1. Magnetspeichervorrichtung mit wahlfreiem Zugriff, umfassend:
einen magnetischen Tunnelkontakt (200),
eine erste (204) und eine zweite (210) Magnetfelderzeugungskomponente,
eine elektrische Energiequelle, umfassend: eine Bitleitung (202), die mit der ersten Magnetfelderzeugungskonponente (204) über einen ersten Anschluss (230) verbunden ist, und eine Wortleitung (214), die mit der zweiten Magnetfelderzeugungskomponente (210) über einen zweiten Anschluss (220) verbunden ist,
und **dadurch gekennzeichnet, dass**:
die erste (204) und die zweite (210) Magnetfelderzeugungskomponente auf gegenüberliegenden Seiten des magnetischen Tunnelkontakts (200) mit dem magnetischen Tunnelkontakt (200) in Kontakt stehen,
ein Pol der elektrischen Energiequelle mit der Bitleitung (202) verbunden ist und ein zweiter Pol mit der Wortleitung (214) verbunden ist, und
der erste (230) und der zweite (220) Anschluss von den Kontaktregionen zwischen der ersten (204) und der zweiten (210) Magnetfelderzeugungskomponente und dem magnetischen Tunnelkontakt (200) seitlich versetzt sind.

2. Vorrichtung nach Anspruch 1, wobei ein elektrischer Strom, der über den magnetischen Tunnelkontakt (200) zwischen der ersten (204) und der zweiten (210) Magnetfelderzeugungskomponente fließt, auch die erste (204) und die zweite (210) Magnetfelderzeugungskomponente entlang dem magnetischen Tunnelkontakt (200) in Richtungen durchläuft, die im Wesentlichen parallel zum magnetischen Tunnelkontakt (200) sind.

3. Vorrichtung nach Anspruch 1 oder 2, wobei der magnetische Tunnelkontakt (200) eine freie Schicht (206) umfasst.

4. Vorrichtung nach Anspruch 3, wobei eine Flächenausdehnung der Oberfläche der freien Schicht, die der ersten Magnetfelderzeugungskomponente (204) zugewandt ist, weniger als ungefähr 0,12 Quadratmikrometer beträgt.

5. Vorrichtung nach einem der Ansprüche 1 bis 3, umfassend eine Digitleitung (512), wobei die zweite Magnetfelderzeugungskomponente (210) und der magnetische Tunnelkontakt (200) zwischen der ersten Magnetfelderzeugungskomponente (204) und der Digitleitung (512) gelegen sind.

6. Vorrichtung nach Anspruch 5, wobei eine Flächenausdehnung der Oberfläche der freien Schicht, die der ersten Magnetfelderzeugungskomponente (204) zugewandt ist, mehr als ungefähr 0,3 Quadratmikrometer beträgt.

7. Verfahren zum Ansteuern einer Magnetspeichervorrichtung mit wahlfreiem Zugriff nach einem der vorhergehenden Ansprüche, wobei das Verfahren umfasst:
Schalten der Vorrichtung über einen ersten elektrischen Strom, der die erste (204) und die zweite (210) Magnetfelderzeugungskomponente in Richtungen durchläuft, die im Wesentlichen parallel zu Direktverbindungen zwischen der ersten (204) und der zweiten (210) Magnetfelderzeugungskomponente und dem magnetischen Tunnelkontakt (200) sind.

8. Verfahren nach Anspruch 7, umfassend:
Lesen eines Zustands der Magnetspeichervorrichtung mit wahlfreiem Zugriff über eine Spannung, die über die erste (204) und die zweite (210) Magnetfelderzeugungskomponente angelegt ist, wobei ein zugeordneter elektrischer Strom durch den magnetischen Tunnelkontakt (200) geringer ist als der erste elektrische Strom.

9. Verfahren nach Anspruch 7 oder 8, wobei die Magnetspeichervorrichtung mit wahlfreiem Zugriff eine Digitleitung (512) umfasst und die zweite Magnetfelderzeugungskomponente (210) und der magnetische Tunnelkontakt (200) zwischen der ersten Magnetfelderzeugungskomponente (204) und der Digitleitung (512) gelegen sind, wobei das Schalten umfasst:
Anlegen eines zweiten elektrischen Stroms an der Digitleitung (512) gleichzeitig mit dem ersten elektrischen Strom.

10. Verfahren zur Herstellung einer Magnetspeichervorrichtung, wobei das Verfahren **dadurch gekennzeichnet ist, dass** es umfasst:
Ausbilden eines Transistors in einem Substrat (40),
Ausbilden einer ersten Isolier-Zwischenschicht (42) auf dem Substrat (40), die den Transistor bedeckt,
Ausbilden eines Durchgangslochs in der ersten Isolier-Zwischenschicht (42), das eine Source des Transistors freilegt,
Füllen des Durchgangslochs mit einem leitfähigen Stift (44),
Ausbilden einer ersten Magnetfelderzeugungskomponente (46) auf der ersten Isolier-Zwischenschicht, die mit dem leitfähigen Stift (44) in Kontakt steht, und
Ausbilden eines magnetischen Tunnelkontakts (48), MTJ, auf einer vorgegebenen Region der ersten Magnetfelderzeugungskomponente (46) seitlich versetzt getrennt vom leitfähigen Stift (44),
Ausbilden einer zweiten Isolier-Zwischenschicht (50) auf der ersten Isolier-Zwischenschicht (42), die die erste Magnetfelderzeugungskomponente (46) und den MTJ (48) bedeckt,
Planarisieren der zweiten Isolier-Zwischenschicht (50), bis eine Oberseite des MTJ (48) freigelegt ist,
Ausbilden einer zweiten Magnetfelderzeugungskomponente (52) auf der zweiten Isolier-Zwischenschicht (50), die einen ersten Abschnitt aufweist, der mit der freigelegten Oberseite des MTJ (48) in Kontakt steht, Ausbilden einer dritten Isolier-Zwischenschicht (52) auf der zweiten Isolier-Zwischenschicht (50), die die zweite Magnetfelderzeugungskomponente (52) bedeckt,
Ausbilden eines Durchgangslochs (h2) in der dritten Isolier-Zwischenschicht (52), das einen zweiten Abschnitt der zweiten Magnetfelderzeugungskomponente freilegt, seitlich versetzt vom ersten Abschnitt und
Ausbilden einer Bitleitung (BL) auf der dritten Isolier-Zwischenschicht (54), die das Durchgangsloch (h2) füllt, das die zweite Magnetfelderzeugungskomponente (52) freilegt.

11. Verfahren nach Anspruch 10, wobei die erste Magnetfelderzeugungskomponente (46) eine Pad-Schicht einer unteren Elektrode ist, die den leitfähigen Stift (44) und den MTJ verbindet.

12. Verfahren nach Anspruch 11, wobei die Breite und die Dicke der Pad-Schicht der unteren Elektrode 100 nm oder weniger betragen.

13. Verfahren nach Anspruch 10, 11 oder 12, wobei der MTJ und die Bitleitung um mindestens 300 nm getrennt sind.

14. Verfahren nach einem der Ansprüche 10 bis 13, wobei der Transistor einen ersten und einen zweiten Transistor umfasst, die eine Drain gemeinsam nutzen, das Durchgangsloch ein erstes und ein zweites Durchgangsloch umfasst, die jeweils eine Source des ersten und zweiten Transistors freilegen, der leitfähige Stift einen ersten und einen zweiten leitfähigen Stift umfasst, die jeweils das erste und das zweite Durchgangsloch füllen, die erste Magnetfelderzeugungskomponente eine erste Pad-Schicht der unteren Elektrode mit einem ersten Endabschnitt umfasst, der mit dem ersten leitfähigen Stift in Kontakt steht, und eine zweite Pad-Schicht der unteren Elektrode mit einem ersten Endabschnitt umfasst, der mit dem zweiten leitfähigen Stift in Kontakt steht, und der MTJ einen ersten MTJ umfasst, der auf einem zweiten Endabschnitt der ersten Pad-Schicht der unteren Elektrode ausgebildet ist, und einen zweiten MTJ umfasst, der auf einem zweiten Endabschnitt der zweiten Pad-Schicht der unteren Elektrode ausgebildet ist.

15. Verfahren nach Anspruch 14, wobei die zweite Magnetfelderzeugungskomponente (52) eine erste Pad-Schicht der oberen Elektrode mit einem ersten Endabschnitt, der mit einer Oberseite des ersten MTJ in Kontakt steht, und einen zweiten Endabschnitt, der mit der Bitleitung (BL) in Kontakt steht, und eine zweite Pad-Schicht der oberen Elektrode mit einem ersten Endabschnitt, der mit einer Oberseite des zweiten MTJ in Kontakt steht, und einen zweiten Endabschnitt, der mit der Bitleitung (BL) in Kontakt steht, umfasst.

16. Verfahren nach einem der Ansprüche 10 bis 15, wobei die erste (46) und die zweite (52) Magnetfelderzeugungskomponente zueinander senkrecht stehen.

17. Verfahren nach einem der Ansprüche 10 bis 16, wobei die zweite Magnetfelderzeugungskomponente (52) eine Pad-Schicht der oberen Elektrode ist, die mit der Bitleitung (BL) und der Oberseite des MTJ (48) in Kontakt steht.

18. Verfahren nach Anspruch 17, wobei die Breite und die Dicke der Pad-Schicht der oberen Elektrode 100 nm oder weniger betragen.

19. Verfahren nach Anspruch 15, wobei die erste und zweite Pad-Schicht der unteren Elektrode und die erste und zweite Pad-Schicht der oberen Elektrode die gleiche Dicke und die gleiche Breite aufweisen.

## Revendications

1. Dispositif de mémoire magnétique à accès sélectif comprenant :
une jonction tunnel magnétique (200) ;
des premier (204) et second (210) composants de génération de champ magnétique ;
une source d'alimentation électrique comprenant : une ligne de bits (202) connectée au premier composant de génération de champ magnétique (204) par l'intermédiaire d'une première connexion (230) ; et
une ligne de mots (214) connectée au second composant de génération de champ magnétique (210) par l'intermédiaire d'une seconde connexion (220),
et **caractérisé en ce que** :
les premier (204) et second (210) composants de génération de champ magnétique sont en contact avec la jonction tunnel magnétique (200) au niveau des côtés opposés de la jonction tunnel magnétique (200) ;
un pôle de la source d'alimentation électrique est connecté à la ligne de bits (202) et un second pôle est connecté à la ligne de mots (214) ; et
les première (230) et seconde (220) connexions sont décalées latéralement des régions de contact entre les premier (204) et second (210) composants de génération de champ magnétique et la jonction tunnel magnétique (200).

2. Dispositif selon la revendication 1, dans lequel le courant électrique s'écoulant entre les premier (204) et second (210) composants de génération de champ magnétique par l'intermédiaire de la jonction tunnel magnétique (200) traverse également les premier (204) et second (210) composants de génération de champ magnétique le long de la jonction tunnel magnétique (200) dans des directions qui sont sensiblement parallèles à la jonction tunnel magnétique (200).

3. Dispositif selon la revendication 1 ou la revendication 2, dans lequel la jonction tunnel magnétique (200) comprend une couche libre (206).

4. Dispositif selon la revendication 3, dans lequel une zone de la surface de la couche libre faisant face au premier composant de génération de champ magnétique (204) a une surface inférieure à approximativement 0,12 µm².

5. Dispositif selon l'une quelconque des revendications 1 à 3, comprenant une ligne de chiffres (512), où le second composant de génération de champ magnétique (210) et la jonction tunnel magnétique (200) sont situés entre le premier composant de génération de champ magnétique (204) et la ligne de chiffres (512).

6. Dispositif selon la revendication 5, dans lequel une zone de la surface de la couche libre faisant face au premier composant de génération de champ magnétique (204) a une surface supérieure à approximativement 0,3 µm².

7. Procédé pour contrôler un dispositif de mémoire magnétique à accès sélectif selon l'une quelconque des revendications précédentes, le procédé comprenant l'étape consistant à :
commuter le dispositif par l'intermédiaire d'un courant électrique traversant les premier (204) et second (210) composants de génération de champ magnétique dans des directions sensiblement parallèles aux connexions directes entre les premier (204) et second (210) composants de génération de champ magnétique et la jonction tunnel magnétique (200).

8. Procédé selon la revendication 7, comprenant l'étape consistant à :
lire un état du dispositif de mémoire magnétique à accès sélectif par l'intermédiaire d'une tension appliquée à travers les premier (204) et second (210) composants de génération de champ magnétique, où un courant électrique correspondant traversant la jonction tunnel magnétique (200) est inférieur au premier courant électrique.

9. Procédé selon la revendication 7 ou la revendication 8, dans lequel le dispositif de mémoire magnétique à accès sélectif comprend une ligne de chiffres (512) et le second composant de génération de champ magnétique (210) et la jonction tunnel magnétique (200) sont situés entre le premier composant de génération de champ magnétique (204) et la ligne de chiffres (512), la commutation comprenant l'étape consistant à :
appliquer un second courant électrique à la ligne de chiffres (512) en même temps que le premier courant électrique.

10. Procédé de fabrication d'un dispositif de mémoire magnétique, le procédé étant **caractérisé en ce qu'**il comprend les étapes consistant à :
former un transistor sur un substrat (40) ;
former sur le substrat (40) une première couche isolante intercalaire (42) recouvrant le transistor ;
former sur la première couche isolante intercalaire (42) un trou d'interconnexion exposant une source du transistor ;
remplir le trou d'interconnexion avec une fiche conductrice (44) ;
former sur la première couche isolante intercalaire un premier composant de génération de champ magnétique (46) contactant la fiche conductrice (44) ; et
former une jonction tunnel magnétique (48), MTJ, sur une région prédéterminée du premier composant de génération de champ magnétique (46) décalée latéralement par rapport à la fiche conductrice (44) ;
former sur la première couche isolante intercalaire (42) une deuxième couche isolante intercalaire (50) recouvrant le premier composant de génération de champ magnétique (46) et la MTJ (48) ;
aplanir la deuxième couche isolante intercalaire (50) jusqu'à ce qu'une surface supérieure de la MTJ (48) soit exposée ;
former sur la deuxième couche isolante intercalaire (50) un second composant de génération de champ magnétique (52) ayant une première partie en contact avec la surface supérieure exposée de la MTJ (48) ;
former sur la deuxième couche isolante intercalaire (50) une troisième couche isolante intercalaire (52) recouvrant le second composant de génération de champ magnétique (52) ;
former dans la troisième couche isolante intercalaire (52) un trou d'interconnexion (h2) exposant une seconde partie du second composant de génération de champ magnétique décalée latéralement par rapport à la première partie ; et
former sur la troisième couche isolante intercalaire (54) une ligne de bits (BL) remplissant le trou d'interconnexion (h2) exposant le second composant de génération de champ magnétique (52).

11. Procédé selon la revendication 10, dans lequel le premier composant de génération de champ magnétique (46) est une couche d'électrode inférieure connectant la fiche conductrice (44) et la MTJ.

12. Procédé selon la revendication 11, dans lequel la largeur et l'épaisseur de la couche d'électrode inférieure sont inférieures ou égales à 100 nm.

13. Procédé selon les revendications 10, 11 ou 12, dans lequel la MTJ et la ligne de bits sont séparées d'au moins 300 nm.

14. Procédé selon l'une quelconque des revendications 10 à 13, dans lequel le transistor comprend des premier et second transistors qui partagent un drain, le trou d'interconnexion comprend des premier et second trous d'interconnexion exposant respectivement les sources des premier et second transistors, la fiche conductrice comprend des première et seconde fiches conductrices remplissant respectivement les premier et second trous d'interconnexion, le premier composant de génération de champ magnétique comprend une première couche d'électrode inférieure ayant une première partie d'extrémité en contact avec la première fiche conductrice et une seconde couche d'électrode inférieure ayant une première partie d'extrémité en contact avec la seconde fiche conductrice, et la MTJ comprend une première MTJ formée sur une seconde partie d'extrémité de la première couche d'électrode inférieure et une seconde MTJ formée sur une seconde partie d'extrémité de la seconde couche d'électrode inférieure.

15. Procédé selon la revendication 14, dans lequel le second composant de génération de champ magnétique (52) comprend une première couche d'électrode supérieure ayant une première partie d'extrémité en contact avec une surface supérieure de la première MTJ et une seconde couche d'électrode supérieure ayant une première partie d'extrémité en contact avec une surface supérieure de la seconde MTJ et une seconde partie d'extrémité en contact avec la ligne de bits (BL).

16. Procédé selon l'une quelconque des revendications 10 à 15, dans lequel les premier (46) et second (52) composants de génération de champ magnétique sont perpendiculaires l'un à l'autre.

17. Procédé selon l'une quelconque des revendications 10 à 16, dans lequel le second composant de génération de champ magnétique (52) est une couche d'électrode supérieure connectant la ligne de bits (BL) et la surface supérieure de la MTJ (48).

18. Procédé selon la revendication 17, dans lequel la largeur et l'épaisseur de la couche d'électrode supérieure sont inférieures ou égales à 100 nm.

19. Procédé selon la revendication 15, dans lequel les première et seconde couches d'électrode inférieure et les première et seconde couches d'électrode supérieure ont la même largeur et la même épaisseur.
